Europäisches Patentamt

**European Patent Office**

**Office européen des brevets**

(19)

(11) Veröffentlichungsnummer: **0 309 733**

**A1**

(12) **EUROPÄISCHE PATENTANMELDUNG**

(21) Anmeldenummer: **88113762.4**

(22) Anmeldetag: **24.08.88**

(51) Int. Cl.⁴: **C23C 14/32 , C23C 14/16**

(30) Priorität: **26.09.87 DE 3732563**

(43) Veröffentlichungstag der Anmeldung:
**05.04.89 Patentblatt 89/14**

(84) Benannte Vertragsstaaten:
**AT BE CH DE ES FR GB GR IT LI LU NL SE**

(71) Anmelder: **Repenning, Detlev, Dr.**
**Krabbenhöhe 12**
**D-2057 Reinbek(DE)**

(72) Erfinder: **Repenning, Detlev, Dr.**
**Krabbenhöhe 12**
**D-2057 Reinbek(DE)**

(74) Vertreter: **Schöning, Hans-Werner, Dipl.-Ing.**
**Patentanwälte Niedmers & Schöning**
**Jessenstrasse 4**
**D-2000 Hamburg 50(DE)**

(54) **Verfahren zur Herstellung von wenigstens 2-komponentigen Schichten mit hochharten und/oder reibarmen Eigenschaften.**

(57) Es wird ein Verfahren zur Herstellung von Schichten mit hochharten und/oder reibarmen Eigenschaften, insbesondere auf der Basis mikro- oder nanodisperser Carbid-Kohlenstoffschichten vorgeschlagen. Dabei wird in einem Vakuum auf einem elektrischen Potential befindliches Targetmaterial in ein Targetplasma überführt. Das Targetplasma gelangt auf das Substrat, das auf einem annähernd gleichen oder einem höheren elektrischen Potential als das Targetmaterial liegt, um dort die gewünschte Schicht auszubilden. Das Targetmaterial wird aus Vanadium gebildet, wobei das Vanadium mittels eines Lichtbogens zu einem Vanadiumplasma verdampft wird. Die Überführung des Vanadiums als Targetmaterial in das Plasma erfolgt in der Gasphase ionisierten Kohlenstoffs. Das Verfahren wird derart betrieben, daß dabei Vanadiumcarbid und Kohlenstoff entsteht, wobei Vanadiumcarbid und Kohlenstoff auf dem Substrat die sich nachfolgend ausbildende Schicht bilden.

EP 0 309 733 A1

## Verfahren zur Herstellung von wenigstens 2-komponentigen Schichten mit hochharten und/oder reibarmen Eigenschaften

Die Erfindung betrifft ein Verfahren zur Herstellung von Schichten mit hochharten und/oder reibarmen Eigenschaften, insbesondere auf der Basis mikro- oder nanodisperser Carbid-Kohlenstoffschichten, bei dem in einem Vakuum sich auf einem annähernd gleichen oder einem höheren elektrischen Potential befindliches Targetmaterial in ein Targetplasma überführt wird, das auf ein Substrat, das auf einem höheren elektrischen Potential als das Targetmaterial liegt, zur Bildung der Schicht gelangt.

Die Herstellung derartiger Schichten, insbesondere kohlenstoffreicher Carbid-Composite-Verbindungen, erfolgt heutzutage unter Anwendung der bekannten PVD-Verfahren (Magnetronsputtern). Dabei wird in einem hochvakuumrezipienten Metall mittels Argon-Ionenbeschuß zerstäubt. Durch Hinzufügen eines kohlenstoffhaltigen Gases, beispielsweise Azetylen, reagiert das Metall an der Oberfläche eines auf negativem Potential liegenden Substrats, das ein zu beschichtendes Werkstück sein kann, zu einem Metallcarbid oder bei entsprechend hohem Druck des Azetylens zu sogenannntem Metallkohlenstoff.

Um jedoch Schichten der eingangs genannten Art in unbegrenzter Zahl reproduzieren zu können, d. h. mit Eigenschaften, die fortwährend bei allen zu beschichtenden Werkstücken oder dergl. gleiche sind, ist es nötig, daß der Kohlenwasserstoff im Plasma hochionisiert ist.

Der Nachteil des bekannten PVD-Verfahrens liegt darin, daß bei der bekannten PVD-Metallzerstäubungstechnik der Ladungsanteil der zerstaubten Metallteilchen nur bei ca. 1 - 5 % liegt. Ein anderer Nachteil des bekannten PVD-Verfahrens bei der Ausbildung derartiger Schichten liegt darin, daß die damit zu erreichenden Schichten ungleichmäßig in deren Bildung und Aufbau sind, wobei der sich aus dem vorerwähnten geringen Ladungsanteil ergebende Nachteil des bekannten Verfahrens auch in einer verhältnismäßig geringen Beschichtungsrate widerspiegelt, so daß der Aufbau einer Schicht mittels des bekannten Verfahrens eine verhältnismäßig lange Zeit braucht.

Schließlich hat sich gezeigt, daß das bekannte PVD-Verfahren zur Ausbildung der Schichten dann nur bedingt geeignet ist, wenn es darauf ankommt, daß die Schichten sehr gute Hafteigenschaften aufweisen, beispielsweise wenn Eisenwerkstoffe beschichtet werden sollen und die darauf auszubildenden Schichten sehr gut auf dem Werkstück bzw. Substrat haften sollen.

Es ist Aufgabe der vorliegenden Erfindung, ein Verfahren zu schaffen, bei dem im Vergleich zu den bekannten Verfahren Schichten hergestellt werden können, die fortwährend gleiche Eigenschaften und die gegenüber den bekannten Verfahren hergestellten Schichten bessere physikalische und chemische Eigenschaften haben, wobei das Verfahren gegenüber dem bekannten Verfahren mit einfacheren Mitteln ausführbar sein soll und die Schichten sowohl harte als auch reibarme Eigenschaften aufweisen sollen.

Gelöst wird die Aufgabe gemäß der Erfindung dadurch, daß das Targetmaterial aus Vanadium gebildet wird, das mittels eines Lichtbogens zu einem Vanadiumplasma verdampft wird, wobei die Überführung des Vanadiums in das Plasma derartig in der Gasphase ionisierten Kohlenstoffs erfolgt, das sowohl Vanadiumcarbid als auch Kohlenstoff die auf dem Substrat sich nachfolgend ausbildende Schicht bilden.

Ein Vorteil des erfindungsgemäßen Verfahrens besteht im wesentlichen darin, daß bei dieser Art der Verdampfung des Vanadiums bis zu 90 % in der Gasphase ionisiert wird, hingegen bei dem bekannten Verfahren nur ein verschwindend geringer Teil davon. Auch werden durch den hohen Ionisierungsanteil des im Lichtbogen verdampften Metalls besonders günstige Voraussetzungen zum Wachstum von Vanadiumcarbid-Kohlenstoffschichten geschaffen, die leitfähig sind, und die eine erheblich bessere Hafteigenschaft auf allen Metallwerkstoffen, die das Substrat bilden, zeigen, wobei insbesondere die Haftung der nach dem erfindungsgemäßen Verfahren gestellten Schichten auf Eisenwerkstoffen sehr hoch ist.

Das Vanadium hat gegenüber Eisen eine bessere Löslichkeit, woraus sich eine bessere Haftung ergibt.

Ein anderer Vorteil des erfindungsgemäßen Verfahrens liegt darin, daß die mit ihm geschaffenen Schichten eine sehr hohe Schichtductilität aufweisen, wobei die Rißdehnung bei ca. 3 % liegt.

Der weitaus wichtigste Vorteil gegenüber dem bekannten Verfahren liegt jedoch darin, daß durch den Aufbau der mit dem erfindungsgemäßen Verfahren hergestellten Schicht eine bisher vergeblich angestrebte Eigenschaft erreicht wird, daß nämlich die hergestellte Schicht sowohl hart als auch reibarm ist. Diese Eigenschaft wird mit dem erfindungsgemäßen Verfahren dadurch erreicht, daß in der Schicht neben Vanadiumcarbid Kohlenstoff so eingefügt wird, daß in die harte Carbidmatrix dispers gelöster Kohlenstoff eingebaut wird.

Zwar ist aus der Deutschen Patentanmeldung P 37 12 205.3 ein Verfahren zur Herstellung von Schichten mit hochharten diamantähnlichen und/oder reibungsarmen Eigenschaften bekannt. Dieses dort bekannte Verfahren verwendet jedoch als Targetmaterial Kohlenstoff, der zur Ausbildung der diamantähnlichen Schichten in Form festen Targetmaterials vorliegt.

Gemäß einer vorteilhaften Ausgestaltung der Erfindung wird der Kohlenstoff infolge eines Glimmentladungsvorganges an einer auf dem höheren Potential als das Targetmaterial befindlichen Elektrodenanordnung ionisiert. Denkbar ist es, daß der ionisierte Kohlenstoff auch an anderer Stelle erzeugt und in das Vakuum eingebracht wird, vorteilhafterweise wird jedoch durch die Ionisierung des Kohlenstoffs durch Glimmentladung im Vakuum bzw. der Ionisierungsgrad auf einfache Weise geregelt, so daß das Verfahren insgesamt gemäß dieser Ausgestaltung einfacher durchgeführt werden kann.

Zur Erzeugung des ionisierten Kohlenstoffs werden gemäß einer weiteren vorteilhaften Ausgestaltung der Erfindung Kohlenwasserstoffe wie Methan, Propan, Azetylen oder Butadien verwendet. Grundsätzlich eignen sich dazu aber auch andere, hier nicht gesondert aufgeführte, Kohlenwasserstoffe.

Vorzugsweise wird in das Vakuum bzw. zum Kohlenstoff ein nicht reaktives Gas gegeben. Dieses Gas kann vorteilhafterweise Argon sein.

Gemäß einer weiteren vorteilhaften Ausführungsform der Erfindung weist das Kohlenwasserstoffgas bei der Ausführung des Verfahrens einen Druck von $10^{-5}$ bis $10^{-1}$ mbar auf. Es sei aber darauf verwiesen, daß der Druck des Kohlenwasserstoffgases für bestimmte auszubildende Schichten mit bestimmten zu erwartenden Eigenschaften auf bestimmte Werte optimiert werden kann. Schließlich ist gemäß einer weiteren Ausgestaltung des Verfahrens durch vorbestimmte Variation der Substratspannung der Kohlenstoffgehalt der Schicht einstellbar.

Es sei hervorgehoben, daß gemäß dem hier vorgeschlagenen Verfahren auch Mehrfachschichten hergestellt werden können, wobei die einzelnen Schichten neben der erfindungsgemäßen Schicht aus Vanadiumcarbid und darin dispers gelöstem Kohlenstoff auch aus Metallen bzw. Metallegierungen aufgebaut sein können. Es ist darüber hinaus auch denkbar, daß mehrere Schichten aus Vanadiumcarbid und darin dispers gelöstem Kohlenstoff übereinander aufgebaut werden können, wobei die einzelnen Schichten sich dadurch unterscheiden, daß das Verhältnis zwischen Vanadiumcarbid und darin dispers gelöstem Kohlenstoff von Schicht zu Schicht unterschiedlich ist.

Demzufolge ist es vorteilhaft, daß das die Schicht bildende Gemisch aus Vanadiumcarbid und Kohlenstoff in einem beliebigen Verhältnis, vorzugsweise aber in einem Verhältnis von 3 : 1 steht, was bei sehr guten Härteeigenschaften auch sehr gute reibarme Eigenschaften aufweist.

Das Verfahren kann schließlich vorteilhafterweise bei einer Abscheidetemperatur von 200 - 500 °C durchgeführt werden, d. h. bei einer verhältnismäßig niedrigen Temperatur, so daß der zu beschichtende Werkstoff selbst infolge der Temperatur keinerlei atomare oder molekulare Veränderungen erfährt.

Das Verfahren kann grundsätzlich in einem gewöhnlichen Rezipienten durchgeführt werden, in dem über eine Pumpeneinrichtung ein Vakuum erzeugt wird. Über einen Gaseinlaß kann ein beliebiges Kohlenwasserstoffgas, beispielsweise Methan, Propan, Azetylen oder Butadien eingelassen werden. Das Target aus Vanadium ist mit einer geeigneten Spannungsquelle verbunden. Ebenso ist eine Substratelektrode, die beispielsweise das zu beschichtende Werkstück bildet, mit einer Spannungsquelle verbunden. Das elektrische Potential des Substrats (zu beschichtendes Werkstück) ist negativer als das Potential des Targetmatrials. Von einer Lichtbogenquelle wird ein Lichtbogen auf das Targetmaterial gegeben. Infolge der Ausbildung des Lichtbogens wird das Vanadium, das das Target bildet, "verdampft", so daß das Vanadium als Vanadiumplasma in die Gasphase überführt wird. Die Folge ist, daß das "verdampfte" Vanadium dann zu wenigstens 90 % in der Gasphase elektrisch geladen, d. h. ionisiert ist.

Die durch den Lichtbogen erzeugten Vanadiumionen des Vanadiumplasmas driften durch den Glimmentladungsbereich am Werkstück und werden im Kathodenfallraum beschleunigt. Durch Kollosionsprozesse mit nichtionisierten und ionisierten Kohlenstoff- oder Kohlenwasserstoffteilchen werden diese energetisch hoch angeregt und bilden günstige Voraussetzungen zur Ausbildung hochharter kohlenstoffhaltiger Schichten.

Die durch den Lichtbogen "verdampften" Vanadiumionen driften in Richtung Substrat (Werkstück) und reagieren an der Oberfläche mit dem Kohlenstoff des Kohlenwasserstoffs zu mikrodispersen 2-Phasen-Schichten, die aus Carbiden und elementarem Kohlenstoff (mikroskopisch disperses Gemisch) bestehen. Die entstehenden Schichten sind sehr hart und reibarm.

Es sei hervorgehoben, daß der Prozeß gemäß diesem Verfahren in einem Hochvakuum-Rezipienten vorteilhafterweise in einem Druckbereich des Kohlenwasserstoffgases zwischen $10^{-5}$ und $10^{-1}$ mbar abläuft. Das Kohlenwasserstoffgas kann dabei durch nichtreaktive Gase, beispielsweise durch Argon, verdünnt sein.

Gemäß dem Verfahren sind Schichten aufbaubar, die infolge der Zu- bzw. Abnahme der steuerbaren Lichtbogenintensität unterschiedliche Eigenschaften haben. So können beispielsweise harte Vanadiumcarbidschichten bis hin zu reibarmen Vanadiumkohlenstoffschichten mit beispielsweise einem Vanadiumgehalt von nur noch 5 - 10 % erzeugt werden. d. h. Schichten, die zwischen sehr reibarmen und sehr harten Eigenschaften liegen.

Es sei aber darauf verwiesen, daß trotz dieser Variationsmöglichkeit die Schicht aus der harten Vanadiumcarbidmatrix und dem darin gelösten Kohlenstoff immer sowohl gute harte als auch gute reibarme Eigenschaften aufweist, so daß die vorangehend erwähnte extreme Eigenschaft (sehr reibarm, sehr hart) immer nur als besonders auffällig in Erscheinung tretende Eigenschaft anzusehen ist, wobei die jeweils andere Eigenschaft fortwährend gleichzeitig vorhanden ist, gegenüber der jeweils anderen als signifikant in Erscheinung tretenden Eigenschaft jedoch etwas zu zurücksteht.

Durch vorbestimmte Variationen der Substratspannung ist weiterhin der Kohlenstoffgehalt der Schicht einstellbar, der beispielsweise bei einer Spannung von -50 V relativ zu den Wänden des Rezipienten deutlich erhöht werden kann.

Zusammenfassend ist zu sagen, daß mit den gemäß der Erfindung hergestellten Schichten Härten von 3000 HV erreicht werden. Je nach Verhältnis des Vanadiumcarbids zum Kohlenstoff liegt ihre Härte zwischen 1800 - 2500 HV.

Durch die erfindungsgemäße Schicht ist es nun gelungen, Werkstücke wie Gleitlager, Kolbenführungen, Gleitringe oder dergl., die keine Flüssigschmierung erlauben, so zu beschichten, daß sie sowohl hart als auch reibarm sind.

## Ansprüche

1. Verfahren zur Herstellung von Schichten mit hochharten und/oder reibarmen Eigenschaften, insbesondere auf der Basis mikro- oder nanodisperser Carbid-Kohlensstoffschichten, bei dem in einem Vakuum sich auf einem elektrischen Potential befindliches Targetmaterial in ein Targetplasma überführt wird, das auf ein Substrat, das auf einem annähernd gleichen oder einem höheren elektrischen Potential als das Targetmaterial liegt, zur Bildung der Schicht gelangt, dadurch gekennzeichnet, daß das Targetmaterial aus Vanadium gebildet wir, das mittels eines Lichtbogens zu einem Vanadiumplasma verdampft wird, wobei die Überführung des Vanadiums in das Plasma derart in der Gasphase ionisierten Kohlenstoff erfolgt, daß sowohl Vanadiumcarbid als auch Kohlenstoff die auf dem Substrat sich nachfolgend ausbildende Schicht bilden.

2. Verfahren nach Anspruch 1, dadurch gekennzeichnet, daß der Kohlenstoffe infolge eines Glimmentladungsvorganges an einer auf einem niedrigeren Potential als das Targetmaterial befindlichen Elektrode der Elektrodenanordnung ionisiert wird.

3. Verfahren nach einem oder beiden der Ansprüche 1 oder 2. dadurch gekennzeichnet, daß zur Erzeugung des ionisierten Kohlenstoffs Kohlenwasserstoffe wie Methan, Propan, Azetylen oder Butadien verwendet wird.

4. Verfahren nach einem oder beiden der Ansprüche 2 oder 3, dadurch gekennzeichnet, daß das Kohlenwasserstoffgas bei der Ausführung des Verfahrens einen Druck von $10^{-5}$ $10^{-1}$ mbar aufweist.

5. Verfahren nach einem oder mehreren der Ansprüche 1 bis 4, dadurch gekennzeichnet, daß in das Vakuum ein nichtreaktives Gas gegeben wird.

6. Verfahren nach Anspruch 5, dadurch gekennzeichnet, daß das nichtreaktive Gas Argon ist.

7. Verfahren nach einem oder mehreren der Ansprüche 1 bis 6, dadurch gekennzeichnet, daß durch vorbestimmte Variationen der Substratspannung der Kohlenstoffgehalt in der Schicht einstellbar ist.

8. Verfahren nach einem oder mehreren der Ansprüche 1 bis 7, dadurch gekennzeichnet, daß das die Schicht bildende Gemisch aus Vanadiumcarbid und Kohlenstoff in einem beliebigen Verhältnis wählbar ist.

9. Verfahren nach Anspruch 8, dadurch gekennzeichnet, daß das Gemisch Vanadiumcarbid und Kohlenstoff in einem Verhältnis von 3 : 1 steht.

10. Verfahren nach einem oder mehreren der Ansprüche 1 bis 9, dadurch gekennzeichnet, daß dieses bei einer Abscheidetemperatur von 200 - 500° C durchgeführt wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | WO-A-8 702 072 (UNION CARBIDE CORP.) * Figur 1; Ansprüche 1,4,5,8,9,12,16,23-25,31,32 * | 1-6 | C 23 C 14/32 C 23 C 14/16 |
| A | JOURNAL OF VACUUM SCIENCE & TECHNOLOGY/A, Band 3, Nr. 3, Teil 1, Mai/Juni 1985, Seiten 553-560, American Vacuum Society, Woodbury, NY, US; R.F. BUNSHAH et al.: "Plasma assisted physical vapor deposition processes: A review" * Seite 554, Spalten 1,2 * | 1-4 | |
| A | THIN SOLID FILMS, Band 107, Nr. 1, September 1983, Seiten 21-38, Elsevier Sequoia, Lausanne, CH; R.F. BUNSHAH: "Processes of the activated reactive evaporation type and their tribological applications" * Seite 28, Zeilen 1-4; Seite 28, Zeilen 15-21; Seite 30, Zeilen 1-6; Seite 30, Zeilen 35-42 * | 1 | |
| A | US-A-4 540 596 (R.R. NIMMAGADDA) * Spalte 3, Zeile 64 - Spalte 4, Zeile 35; Spalte 7, Zeilen 20-35 * | 2-4,10 | **RECHERCHIERTE SACHGEBIETE (Int. Cl.4)** C 23 C |

Der vorliegende Recherchenbericht wurde für alle Patentansprüche erstellt

| Recherchenort | Abschlußdatum der Recherche | Prüfer |
|---|---|---|
| DEN HAAG | 02-12-1988 | JOFFREAU P.O. |